# EUROPEAN PATENT SPECIFICATION

(11) **EP 0 466 274 B1**
(45) Date of publication and mention of the grant of the patent: **16.10.1996**
(21) Application number: 91201794.4
(22) Date of filing: 09.07.1991
(51) Int. Cl.: G01R 27/02, G01R 27/14, G01R 31/26, G01R 27/20

(54) **Method and apparatus for resistance measurements on a semiconductor element**
Verfahren und Apparat zur Wiederstandsmessung in Halbleiterelementen
Procédé et appareil pour mesurer la résistance sur des éléments semi-conducteurs

(30) Priority: 09.07.1990 EP 90201853; 13.12.1990 NL 9002749
(43) Date of publication of application: 15.01.1992
(73) Proprietor: Interuniversitair Micro-Elektronica Centrum vzw, B-3030 Leuven-Heverlee (BE)
(72) Inventor: Vandervorst, Wilfried, B-2800 Mechelen (BE); Meuris, Marc, B-3140 Keerbergen (BE)
(74) Representative: Land, Addick Adrianus Gosling

(56) References cited:
- DE-A- 3 843 877
- IBM TECHNICAL DISCLOSURE BULLETIN, vol. 26, no. 7B, December 1983, pages 3579- 3580, New York, US; W.R. SMITH: "Closed-loop control of the "Z" stage of a wafer prober"
- INTERNATIONAL TEST CONFERENCE 1989, PROCEEDINGS, Washington, DC, 29th - 31st August 1989, pages 208-215, IEEE, New York, US; N. NADEAU et al.: "An analysis of tungsten probes' effect on yield in a production wafer probe environment"
- RADIO FERNSEHEN ELEKTRONIK, vol. 34, no. 7, July 1985, pages 415-417, Berlin, DE; F. BAGE: "Elektrisches Kontaktverhalten von Sondennadeln"
- ELEKTRIE, vol. 25, no. 8, August 1971, pages 303-304; B. NOVOTNY: "Verfahren zur Ermittlung von Kontaktwiderständen"
- Journal of Vacuum Science and Technology, B 12(1), Jan/Feb 1994, pages 304-311; J.SNAUWAERT, I. CZECH et al.: "Towards a physical understanding of spreading resistance probe technique profiling".
- Nuclear instruments and methods in physics research B 96, 1995, pages 123-132; W. VANDERVORST et al. "On the determination of two-dimensional carrier distributions".

## Description

A known technique for measurement on a semiconductor element is called Spreading Resistance Probe. A semiconductor element is herein cut obliquely and the resistance between in each case two probe points placed on the surface is measured. These probe points or conductors are placed at an interval of approximately 15 to 50 µm. The angle of inclination is in the region of several minutes to several degrees. The conductors are stepped over the obliquely cut portions with a step size in each case of 2.5 to 5 µm. In the SRP technique the resistance measurement can take place with both direct voltage and alternating voltage. A known technique is described in Solid State Technology, vol. 27, no. 12, December 1984, US, pages 125-132, R. Brennan et al "Determination of Diffusion Characteristics Using Two- and Four -point Probe Measurements", wherein a method is disclosed for measuring the resistance or conductivity between two or more conductors which are placed against a semiconductor element, wherein the conductors are held under constant pressure relative to the semiconductor element in order to bring the contact resistance between the conductors and the semiconductor element to a predetermined value and hold said contact resistance at that value during measuring.

A problem of prior art arrangements is the deviation in the contact resistance between conductor and semiconductor element. The point of the conductor is accurately polished, which can sometimes take days, until the contact resistance on a calibration sample reaches a predetermined value. Even after the time-consuming calibration of the points of the conductors the deviation in the contact resistance results in inaccuracies in the measurements.

The present invention has for its object to provide a novel method wherein the accuracy of resistance measurements on a semiconductor element is considerably improved.

The present invention provides an improvement to the above method, in that the position of the conductors relative to the semiconductor element is controlled with piezo-crystals of an Atomic Force Microscope (AFM) or Scanning Tunneling Microscope (STM) arrangement, wherein a first of said piezo-crystals controls the pressure or distance of said conductors relative to the semiconductor element, and two other piezo-crystals control the position of said conductors along the surface of the semiconductor element.

Further the present invention provides a STM arrangement for performing such method.

Furthermore the present invention provides an AFM arrangement for performing the above mentioned method.

Further details, features and advantages of the present invention will become apparent in the light of the following description of a preferred embodiment according to the present invention with reference to the annexed drawing, in which:
Fig. 1 shows a graph of a current-voltage characteristic measured on a first semiconductor element and according to a first preferred method according to the present invention; and
Fig. 2 shows a graph of a current-voltage characteristic measured on a second semiconductor element and according to a second preferred method according to the present invention.

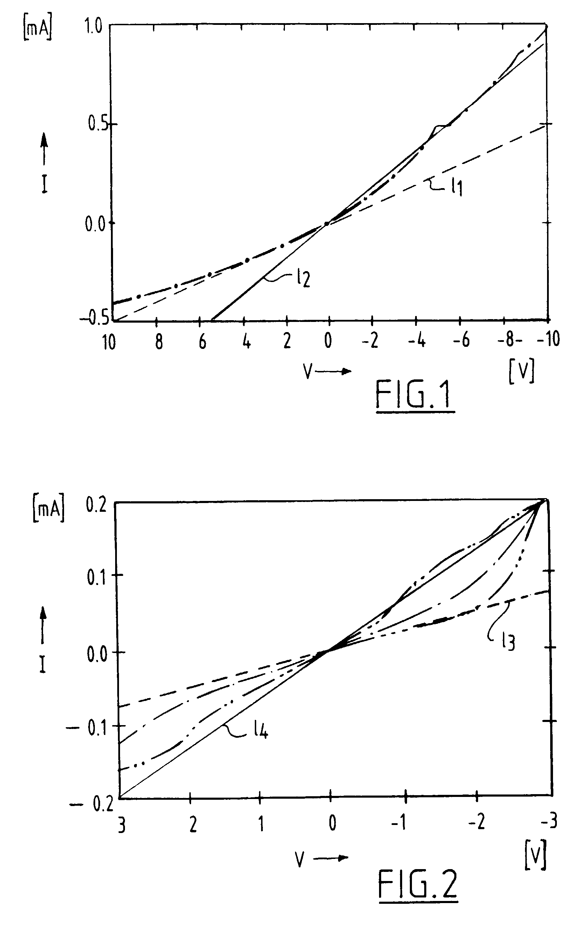

Fig. 1 and 2 are measured using an AFM arrangement (Atomic Force Microscopy). Herein a semiconductor element is movable three-dimensionally with piezo-crystals, a first of which adjusts the pressure or distance of a conducting needle relative to the semiconductor element, while two others enable a movement over the surface of the semiconductor element. A laser beam is directed onto the contact point of the conductor and the semiconductor element. The reflection of the laser beam is picked up in a photodiode, wherein the output of the photodiode is fed back to the first mentioned piezo-crystal.

In the measured graphs use is made of a tungsten wire of 20 µm diameter which is cut to a point. The curve of fig. 1 is measured on a semiconductor element with a relatively high resistivity, ρ ≈ 4.7 Ω.cm. Applying a pressure force of constant value between the conductor and the semiconductor element results in an approximately linear current-voltage characteristic l₁ at negative voltage and l₂ at positive voltage.

Fig. 2 shows measurements on a substrate with a comparatively smaller resistivity ρ ≈ 0.0084 Ω.cm. Different measurements are indicated with different curves in fig. 2 and show an approximately linear relation (l₃ and l₄), wherein the angles of slope of the lines (l₃ and l₄) are dependent on the applied pressure between conductor and semiconductor element.

By applying the pressure force between the semiconductor element and the conductor, this conductor penetrates through a thin oxide layer which in practice is almost always present on the semiconductor element. The pressure force can be held very constant because of feedback to the first mentioned piezo-crystal. Using the two above mentioned piezo-crystals the conductors are moved over the surface for measuring the resistance or conductivity along the sloping surface, wherewith the resistance at different depths in the semiconductor element becomes known.

Another technique which makes use in accurate manner of the control of a conductor over a for instance semiconducting element is so-called Scanning Tunneling Microscopy, wherein use is made of the tunnel flow between conductor and that element for holding the conductor at constant distance relative to the surface of that element. The oxide layer over the semiconductor element can form a problem here.

An important novel feature of the method according to the present invention relates to the possibility of measuring either with DC current and/or voltage, or AC voltage or current.

Good results have been obtained by measuring with AC voltage and using a DC bias voltage.

## Claims

1. A method for measuring the resistance or conductivity between two or more conductors which are placed against a semiconductor element, wherein the conductors are held at a constant distance and/or under constant pressure relative to the semiconductor element in order to bring the contact resistance between the conductors and the semiconductor element to a predetermined value and hold said contact resistance at that value during measuring,
**characterized in that** the position of the conductors relative to the semiconductor element is controlled with piezo-crystals of an Atomic Force Microscope (AFM) or a Scanning Tunneling Microscope (STM) arrangement, wherein a first of said piezo-crystals controls the pressure or distance of said conductors relative to the semiconductor element, and two other piezo-crystals control the position of said conductors along the surface of the semiconductor element.

2. A method according to claim 1, wherein the conductor is manufactured from tungsten.

3. A method according to claim 2, wherein use is made of a tungsten thread of 20 µm diameter on which a point has been cut.

4. A method according to claim 1, 2 or 3, wherein a force is applied between the semiconductor element and the conductor such that the latter penetrates through the layer of natural oxide on the semiconductor element.

5. A method according to any one of claims 1-4, using DC voltage or current and/or AC voltage or current.

6. Scanning Tunneling Microscope (STM) arrangement for performing a method according to any one of claims 1-5.

7. Atomic Force Microscope (AFM) arrangement for performing a method according to any one of claims 1-5.

## Patentansprüche

1. Verfahren zur Messung des Widerstandes oder der Leitfähigkeit zwischen zwei oder mehreren Leitern, die auf einem Halbleiterelement angebracht sind, wobei die Leiter in einem konstanten Abstand und/oder konstantem Druck bezüglich des Halbleiterelementes gehalten sind, um den Kontaktwiderstand zwischen den Leitern und dem Halbleiterelement auf einem vorbestimmten Wert zu halten und den Kontaktwiderstand während der Messung auf diesem Wert zu halten,
**dadurch gekennzeichnet**,
daß die Position der Leiter bezüglich des Halbleiterelementes durch Piezokristalle einer Atomar-Kraftmikroskop(AFM)- oder einer Raster-Tunnelmikroskop(STM)-Anordnung gesteuert wird, wobei ein erster der Piezokristalle den Druck oder den Abstand der Leiter bezüglich des Halbleiterelementes steuert und zwei andere Piezokristalle die Position der Leiter auf der Fläche des Halbleiterelementes steuern.

2. Verfahren nach Anspruch 1,
bei dem der Leiter aus Wolfram gefertigt ist.

3. Verfahren nach Anspruch 2,
bei dem ein Wolframfaden mit 20 µm Durchmesser verwendet wird, an dem eine punktförmige Spitze geschnitten ist.

4. Verfahren nach Anspruch 1, 2 oder 3,
bei dem eine Kraft zwischen dem Halbleiterelement und dem Leiter ausgeübt wird, so daß letzterer durch die natürliche Oxidschicht auf dem Halbleiterelement hindurchdringt.

5. Verfahren nach einem der Ansprüche 1 bis 4,
wobei eine Gleichspannung oder ein Gleichstrom und/oder Wechselspannung oder Wechselstrom verwendet wird.

6. Raster-Tunnelmikroskop (STM)-Anordnung zur Durchführung eines Verfahrens nach einem der Ansprüche 1 bis 5.

7. Atomar-Kraftmikroskop (AFM)-Anordnung zur Durchführung eines Verfahrens nach einem der Ansprüche 1 bis 5.

## Revendications

1. Procédé pour mesurer la résistance ou la conductivité entre deux ou plusieurs conducteurs qui sont placés contre un élément semi-conducteur, dans lequel les conducteurs sont maintenus à une distance constante et/ou à une pression constante par rapport à l'élément semi-conducteur afin de porter la résistance de contact entre les conducteurs et l'élément semi-conducteur à une valeur prédéterminée et de maintenir ladite résistance de contact à cette valeur pendant la mesure, caractérisé en ce que la position des conducteurs par rapport à l'élément semi-conducteur est commandée par des cristaux piézo-électriques d'un agencement de microscope à force atomique (AFM) ou de microscope à balayage par effet tunnel (STM), dans lequel un premier desdits cristaux piézo-électriques commande la pression ou la distance desdits conducteurs par rapport à l'élément semi-conducteur, et deux autres cristaux piézo-électriques commandent la position desdits conducteurs le long de la surface de l'élément semi-conducteur.

2. Procédé selon la revendication 1, dans lequel le conducteur est fabriqué en tungstène.

3. Procédé selon la revendication 2, dans lequel il est fait usage d'un fil de tungstène d'un diamètre de 20 µm sur lequel un point a été coupé.

4. Procédé selon la revendication 1, 2 ou 3, dans lequel une force est appliquée entre l'élément semi-conducteur et le conducteur afin que ce dernier pénètre à travers la couche d'oxyde naturel présente sur l'élément semi-conducteur.

5. Procédé selon l'une quelconque des revendications 1 à 4, dans lequel on utilise une tension ou un courant continus et/ou une tension ou un courant alternatifs.

6. Agencement de microscope à balayage par effet tunnel (STM) pour mettre en oeuvre un procédé selon l'une quelconque des revendications 1 à 5.

7. Agencement de microscope à force atomique (AFM) pour mettre en oeuvre un procédé selon l'une quelconque des revendications 1 à 5.
